Europäisches Patentamt

European Patent Office

Office européen des brevets

(11) Veröffentlichungsnummer: **0 510 430 A2**

## EUROPÄISCHE PATENTANMELDUNG

(21) Anmeldenummer: **92106084.4**

(51) Int. Cl.5: **G01R 31/308**, G01R 1/067

(22) Anmeldetag: **08.04.92**

(30) Priorität: **22.04.91 DE 4113115**

(43) Veröffentlichungstag der Anmeldung:
**28.10.92 Patentblatt 92/44**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Sölkner, Gerald, Dr. techn.**
**Nauplia Allee 12**
**W-8012 Ottobrunn(DE)**

(54) **Verfahren und Vorrichtung zur Messung des elektrischen Potentials einer Probe mit einer Strahlungssonde.**

(57) Ordnet man einen elektrooptischen Kristall (PK) unmittelbar oberhalb einer geladenen Probe (PR) an, so kann das von der Probe (PR) ausgehende elektrische Streufeld (SF) in den Kristall (PK) eindringen und in diesem Doppelbrechung induzieren. Das Probenpotential ($\phi$(x)) läßt sich daher durch Messung der Polarisation einer den Kristall (PK) im Streufeldbereich durchsetzenden Lasersonde (LA) bestimmen. Das Ausgangssignal (I(x)) der der Messung der Polarisation dienenden Detektoreinheit (P2, DT) ist allerdings starkt verrauscht. Es wird daher vorgeschlagen, einen mit dem Kristall (PK) verbundenen Glasträger (TR) in hochfrequente Schwingungen zu versetzen und damit den Abstand des Kristalls (PK) von der Probe (PR) periodisch zu ändern. Infolgedessen besitzt auch das Ausgangssignal (I (x)) der Detektoreinheit (P2, DT) eine hochfrequente Komponente, deren Amplitude (U) rauscharm gemessen und aufgezeichnet werden kann.

Das aus Electronics Letters Vol. 21, No. 13 (1985), Seiten 568 bis 569 bekannte Verfahren verwendet eine einseitig dielektrisch verspiegelte Kristallplatte mit elektrooptischen Eigenschaften, um die Potentialverteilung in einem Bauelement der Mikroelektronik mit Hilfe einer polarisierten Lasersonde abzubilden. Da man den von der Lasersonde punktweise abgetasteten Sensor unmittelbar oberhalb des Bauelements anordnet, können die von den Leiterbahnen ausgehenden elektrischen Streufelder in den Kristall eindringen und in diesem lokal Doppelbrechung induzieren. Die hierdurch bedingte Änderung der Polarisation der den Kristall im Streufeldbereich durchsetzenden Laserstrahlung wird in einer Detektoreinheit gemessen und in Abhängigkeit vom Ort des Laserfokus auf der Bauelementoberfläche aufgezeichnet.

Während die aus Electronics Letters Vol. 20, No. 20 (1984), Seiten 818 bis 819, Appl. Phys. Letters 47 (10), 1985, Seiten 1083 bis 1084 und US-A-4 681 449 bekannten Meßverfahren die elektrooptischen Eigenschaften des Substratmaterials zur Aufzeichnung von Signalpegeländerungen in Ga-As-Schaltungen ausnutzen, verwendet das in Electronics Letters, Vol. 22, No. 17 (1986), Seiten 918 bis 919 und der US-A-4 618 819 beschriebene Verfahren eine LiTaO$_3$-Kristallspitze, um die im Bereich einer Leiterbahn auftretenden elektrischen Felder mit Hilfe einer die Kristallspitze durchsetzenden Lasersonde stroboskopisch abzutasten.

Weitere Lasermeßverfahren werden in IEEE Journal of Quantum Electronics Vol. 22, No. 1 (1986), Seiten 69 bis 78 und Vol. 24, No. 2 (1988), Seiten 198 bis 220 beschrieben.

Der Erfindung liegt die Aufgabe zugrunde, ein Verfahren und eine Vorrichtung zur rauscharmen Messung elektrischer Potentiale mit einer Strahlungssonde anzugeben. Es soll insbesondere möglich sein, den von der Strahlungsquelle herrührenden Rauschanteil im Meßsignal weitgehend zu unterdrücken. Diese Aufgaben werden erfindungsgemäß durch ein Verfahren nach Patentanspruch 1 und eine Vorrichtung nach Patentanspruch 7 gelöst.

Der mit der Erfindung erzielbare Vorteil besteht insbesondere darin, daß man auch statische Potentiale mit hoher Genauigkeit messen kann. Die Erfindung wird im folgenden anhand der eine Vorrichtung zur Durchführung des Verfahrens betreffenden Zeichnung erläutert.

Zur Messung des statischen Potentials $\phi(x)$ einer Probe PR wird diese auf einen Positioniertisch PT montiert und derart bezüglich eines an einem Glasträger TR befestigten Sensors MS angeordnet, daß die von geladenen Bereichen ausgehenden elektrischen Streufelder SF in den probenseitig dielektrisch verspiegelten Pockelskristall PK eindringen und in diesem Doppelbrechung induzieren. Um das Eindringen der Streufelder SF in den Sensor MS zu erleichtern, ist der aus LiTaO$_3$, LiNbO$_3$ oder ZnSe bestehende Pockelskristall PK mit einer für die zur Messung verwendete Laserstrahlung LA transparenten Schicht TS aus elektrisch leitendem Material, beispielsweise Zinnoxid, überzogen. Liegt diese als Gegenelektrode wirkende Schicht TS auf Masse oder einen konstanten Potential $\phi_G$ , so kann sich im Kristall PK ein weitgehend homogenes elektrisches Feld aufbauen. Der elektrooptische Effekt ist dann im wesentlichen nur noch vom Potential $\phi(x)$ des dem Sensor MS gegenüberliegenden Probenbereichs bzw. von der zwischen der Gegenelektrode TS und der Probe PR aufgebauten Potentialdifferenz $|\phi_G - \phi(x)|$ abhängig.

Zum Nachweis der im Pockelskristall PK induzierten Doppelbrechung wird die von einem cw-Laser Q emittierte Strahlung LA einem Polarisator P1 zugeführt und mit Hilfe einer Linse OL in die Ebene der dielektrischen Schicht TS fokussiert. In dem von elektrischen Feldern durchsetzten Pockelkristall PK spaltet der Laserstrahl LA in zwei sich mit unterschiedlicher Geschwindigkeit ausbreitende Teilstrahlen (ordentlicher bzw. außerordentlicher Strahl) auf. Nach dem zweimaligen Durchlaufen des Sensors MS (Reflexion am dielektrischen Spiegel DS) besitzen diese Teilstrahlen daher eine Phasendifferenz $\delta$ , die gemäß Gleichung 1)

$$\delta = 2\pi \cdot \lambda^{-1} \cdot 2d \cdot (n_{ao} - n_o) \qquad 1)$$

von der Vakuumwellenlänge $\lambda$ der Laserstrahlung LA, der Differenz $n_{ao} - n_o$ der Brechungsindizes des außerordentlichen und ordentlichen Strahls und der Dicke d des Pockelskristalls PK abhängt. Da im Falle des Pockels-Effekts

$$\Delta n = n_{ao} - n_o = P \cdot E \qquad 2)$$

$$P: \text{Pockels-Konstante}$$

gilt und die Feldstärke im Kristall PK dem Potential $\phi(x)$ der dem Sensor MS gegenüberliegenden Probe proportional ist, kann man $\phi$(x) durch Messung der von der Phasendifferenz $\delta$ abhängigen Polarisation der am dielektrischen Spiegel DS reflektierten Laserstrahlung LA' bestimmen. Die von der Linse OL gebündelte und mit Hilfe des halbdurchlässigen Spiegels HS in Richtung eines zweiten Polarisators P2 (Analysator) umgelenkte Laserstrahlung LA' ist im allgemeinen elliptisch polarisiert, so daß man in dem dem Polarisator P2 nachgeschalteten Detektor DT (Photodiode) eine Intensität

$$J = J_o \{ \cos^2\chi - \sin2\alpha \sin2 (\alpha - \chi) \cdot \sin^2 (\delta/2)\} \qquad 3)$$

registriert. Hierbei bezeichnet $J_o$ die Intensität der auf den Sensor MS gerichteten Laserstrahlung LA, $\chi$ den Winkel zwischen den durch P1 und P2 definierten Polarisationsebenen, $\alpha$ den Winkel zwischen der Polarisationsebene der den Sensor MS abtastenden Laserstrahlung LA und der optischen Achse des Pockelskristalls PR und $\delta$ die durch die Gleichungen 1) und 2) gegebene Phasendifferenz. Gleichung 3) vereinfacht sich zu

$$J_\perp = J_o \sin^2 2\alpha \cdot \sin^2(\delta/2) \qquad 4)$$

$$= \text{konst. } \sin^2 (\delta/2)$$

falls man mit gekreuzten Polarisatoren P1 und P2 ( $\chi = \pi/2$) arbeitet. Das ein Maß für die Phasendifferenz $\delta$ und damit auch ein Maß für das Potential $\phi$(x) darstellende Ausgangssignal I(x)~ $J_\perp$ des Detektors DT ist allerdings stark verrauscht. Den Hauptbeitrag liefert hierbei das niederfrequente Rauschen der Laserquelle Q, das man auch durch eine Begrenzung der Bandbreite der Meßelektronik oder durch vielfache Mittelung des Meßsignals nur unzureichend unterdrücken kann.

Um die Potentialmessung in einem durch das Rauschen wenig beeinträchtigten Frequenzbereich vorzunehmen, wird der Abstand des Sensors MS von der Meßstelle periodisch geändert. In dem dargestellten Ausführungsbeispiel geschieht dies mit Hilfe eines von einem Signalgenerator G angesteuerten Piezoelements PS, das den Glasträger TR und damit auch den Pockelskristall PK in hochfrequente Schwingungen versetzt. Die durch die Schwingung hervorgerufene Abstandsänderung beträgt nur wenige Mikrometer. Sie ist aber ausreichend groß, umd die Amplitude des im Detektor DT gemessenen Signals I(x) mit einer durch den Generator G vorgegebenen Frequenz von beispielsweise $f_o = 1$ MHz zu modulieren.

Die Meßelektronik zur Auswertung des Detektorsignals I(x) besteht aus einem die niederfrequenten Rauschanteile unterdrückenden Hochpaßfilter HF und einem Lock-in-Verstärker LIV, an dessen Referenzeingang das Ausgangssignal des Generators G anliegt. Anstelle eines Lock-in-Verstärkers LIV kann man selbstverständlich auch einen phasenempfindlichen Gleichrichter (Synchrongleichrichter, Multiplizierer) mit nachgeschaltetem Tiefpaßfilter verwenden. Am Ausgang der Meßelektronik ist dann eine nahezu rauschfreie Gleichspannung U abgreifbar, deren Höhe der Amplitude der die Frequenz $f_o$ aufweisenden Komponente des Detektorausgangssignals 1(x) proportional ist und die daher auch ein Maß für das Potential $\phi$(x) darstellt. Die Aufzeichnung des Gleichspannungswertes U erfolgt in einem Rechner COM oder einem anderen Speichermedium.

Die erfindungsgemäße Vorrichtung eignet sich insbesondere zum Abtasten bzw. Auslesen der Ladungsdichteverteilung auf einer Probe PR, beispielsweise einer Röntgenbildplatte. Die hierfür erforderliche Horizontalverschiebung der Probe PR bezüglich des Sensors MS wird mit Hilfe des Positioniertisches PT vorgenommen, wobei man das Ausgangssignal U der Meßelektronik ortsabhängig aufzeichnet. Die Ortsinformation liefert hierbei die dem Positioniertisch PT zugeordnete Steuerelektronik.

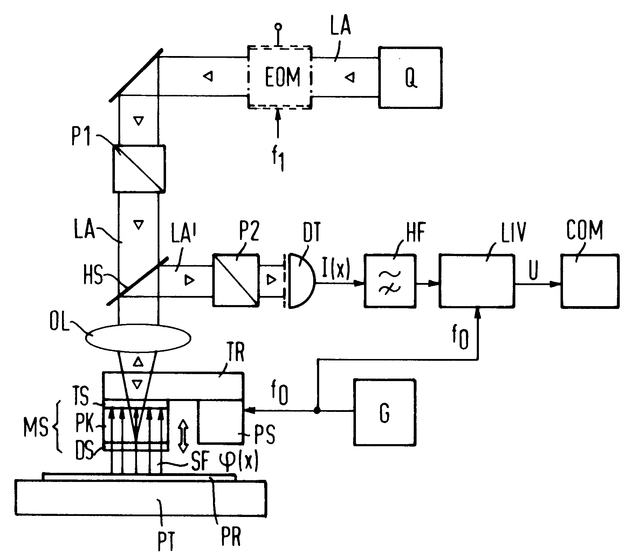

Um auch periodische Potentiale $\phi$ (x, t), wie sie beispielsweise auf Leiterbahnen integrierter Schaltungen auftreten, quasistatisch und weitgehend rauschfrei zu messen, wird der schwingende Sensor MS mit einer gepulsten Lasersonde LA bestrahlt. Falls die Impulswiederholfrequenz $f_1$ der Bedingung $f_2 = n\, f_1$ ($f_2$: Frequenz des Probenpotentials $\phi$ (x, t), n = 1, 2,...) genügt, tastet die Lasersonde LA das Streufeld SF im Kristall PK und damit das Probenpotential $\phi$ (x, t) innerhalb jeder n-ten Periode phasenstarr ab (Stroboskopieprinzip). Die Laserimpulse erzeugt man beispielsweise mit Hilfe eines in Fig. 1 strichpunktiert dargestellten elektrooptischen Modulators EOM, an dessen Steuereingang ein Signal der Frequenz $f_1$ anliegt.

Die Erfindung ist selbstverständlich nicht auf die beschriebenen Ausführungsbeispiele beschränkt. So ist es ohne weiters möglich, die Schwingungsamplitude des Sensors MS zu vergrößern, indem man den Glasträger TR mit einem Metallstreifen verklebt und diesen mit Hilfe des Piezoelements PS in Schwingun-

EP 0 510 430 A2

gen versetzt. Anstelle des Sensors MS kann auch die Probe PR in vertikaler Richtung periodisch verschoben werden.

**Patentansprüche**

1. Verfahren zur Messung des elektrischen Potentials einer Probe mit einer Strahlungssonde,
   **dadurch gekennzeichnet,**
   - daß ein elektrooptisches Medium (PK) derart bezüglich der Probe (PR) angeordnet wird, daß ein von der Probe (PR) ausgehendes elektrisches Streufeld (SF) zumindest teilweise in das elektrooptische Medium (PK) eindringt,
   - daß der Abstand zwischen dem elektrooptischen Medium (PK) und der Probe (PR) mit einer vorgegebenen Zeitabhängigkeit geändert wird,
   - daß die polarisierte Strahlungssonde (LA) auf das elektrooptische Medium (PK) gerichtet wird, so daß diese das elektrooptische Medium (PK) im Streufeldbereich durchsetzt,
   - daß ein von der Polarisation der Strahlungssonde (LA) abhängiges Meßsignal ($I(x)$) erzeugt wird
   - und daß die Amplitude (U) einer die vorgegebene Zeitabhängigkeit aufweisenden Komponente des Meßsignals ($I(x)$) bestimmt und aufgezeichnet wird.

2. Verfahren nach Anspruch 1,
   **dadurch gekennzeichnet,**
   daß der Abstand zwischen dem elektrooptischen Medium (PK) und der Probe (PR) periodisch mit einer ersten Frequenz ($f_o$) geändert wird.

3. Verfahren nach Anspruch 1 oder 2,
   **dadurch gekennzeichnet,**
   daß das elektrooptische Medium (PK) mit einem Halterungselement (TR) verbunden und dieses zu Schwingungen angeregt wird.

4. Verfahren nach einem der Ansprüche 1 bis 3,
   **dadurch gekennzeichnet,**
   daß die Polarisation der an einer dielektrisch verspiegelten ersten Fläche (DS) des elektrooptischen Mediums (PK) reflektierten Strahlung (LA') gemessen wird.

5. Verfahren nach Anspruch 4,
   **dadurch gekennzeichnet,**
   daß eine der ersten Fläche gegenüberliegenden zweite Fläche des elektrooptischen Mediums (PK) mit einer für die Strahlungssonde (LA) transparenten, elektrisch leitenden Schicht (TS) versehen wird und daß diese Schicht (TS) mit einem ersten Potential beaufschlagt wird.

6. Verfahren nach einem der Ansprüche 1 bis 5,
   **dadurch gekennzeichnet,**
   daß das elektrooptische Medium (PK) oberhalb eines ein periodisches Potential aufweisenden Bereichs der Probe (PR) angeordnet wird, daß die Intensität der Strahlungssonde (LA) moduliert wird und daß die Modulationsfrequenz $f_1$ der Bedingung $f_2 = n\, f_1$ genügt, wobei $f_2$ die Frequenz des periodischen Potentials und n eine natürliche Zahl bezeichnet.

7. Vorrichtung zur Messung des elektrischen Potentials einer Probe mit einer Strahlungssonde
   **gekennzeichnet durch**
   - erste Mittel (Q, P1) zur Erzeugung einer polarisierten Strahlungssonde (LA),
   - ein elektrooptisches Medium (PK), das derart bezüglich der Probe (PR) angeordnet ist, daß ein von der Probe (PR) ausgehendes elektrisches Streufeld (SF) zumindest teilweise in das elektrooptische Medium (PK) eindringt,
   - zweite Mittel (TR, PS) zur Änderung des Abstandes zwischen dem elektrooptischen Medium (PK) und der Probe (PR), wobei die zweiten Mittel (TR, PS) mit einem eine vorgegebene Zeitabhängigkeit aufweisenden ersten Signal angesteuert werden,
   - dritte Mittel (OL), die die Strahlungssonde (LA) auf das elektrooptische Medium (PK) richten, so daß die Strahlungssonde (LA) das elektrooptische Medium (PK) im Streufeldbereich durchsetzt,
   - vierte Mittel (P2, TD) zur Erzeugung eines von der Polarisation der Strahlungssonde (LA)

4

abhängigen Meßsignals (I(x)),
- fünfte Mittel (HF, LIV) zur Bestimmung der Amplitude einer die Zeitabhängigkeit des ersten Signals aufweisenden Komponente des Meßsignals (I(x)) und
- Aufzeichnungsmittel (s. OM).

**8.** Vorrichtung nach Anspruch 7,
**dadurch gekennzeichnet,**
daß die zweiten Mittel eine mechanische Schwingungen erzeugende Einheit (PS) und Mittel (TR) zur Übertragung der Schwingungen auf das elektrooptische Medium (PK) aufweisen.

**9.** Vorrichtung nach Anspruch 7 oder 8,
**gekennzeichnet durch**
einen mit einem Signal einer ersten Frequenz ($f_o$) angesteuerten Piezoschwinger (PS).

**10.** Vorrichtung nach einem der Ansprüche 7 bis 9,
**dadurch gekennzeichnet,**
daß die fünften Mittel einen phasenempfindlichen Gleichrichter oder Multiplizierer und einen dem phasenempfindlichen Gleichrichter oder Multiplizierer nachgeschalteten Tiefpaßfilter aufweisen, wobei an einem ersten Eingang des Gleichrichters oder Multiplizierers das erste Signal und an einem zweiten Eingang das Meßsignal (I(x)) anliegt.

**11.** Vorrichtung nach einem der Ansprüche 7 bis 10,
**gekennzeichnet durch**
eine Einrichtung (EOM) zur Modulation der Intensität der Strahlungssonde (LA).